# EUROPÄISCHE PATENTSCHRIFT

(11) **EP 0 994 640 B1**
(45) Veröffentlichungstag und Bekanntmachung des Hinweises auf die Patenterteilung: **19.03.2003**
(21) Anmeldenummer: 99117394.9
(22) Anmeldetag: 04.09.1999
(51) Int. Cl.: H05K 1/02, H05K 3/34

(54) **Verfahren zur Herstellung von Schaltungsanordnungen**
Method of making a circuit assembly
Procédé d' assemblage de circuits

(30) Priorität: 17.09.1998 DE 19842590
(43) Veröffentlichungstag der Anmeldung: 19.04.2000
(73) Patentinhaber: Conti Temic microelectronic GmbH, 90411 Nürnberg (DE)
(72) Erfinder: Heinz, Helmut, 91522 Ansbach (DE); Schuch, Bernhard, 91616 Neusitz (DE)

(56) Entgegenhaltungen:
- EP-A- 0 055 578
- EP-A- 0 869 704

## Beschreibung

In vielen Anwendungsbereichen der Elektrotechnik werden Schaltungsanordnungen mit Bauteilen eingesetzt, bei deren Betrieb eine hohe Verlustleistung auftritt, insbesondere bei Schaltungsanordnungen mit Leistungsbauteilen, wie bsp. bei Leistungsmodulen zur Ansteuerung von Baugruppen o.ä. Die Bauteile der Schaltungsanordnung werden auf einen geeigneten Trägerkörper aufgebracht; bsp. werden in der Kfz-Elektronik oftmals oberflächenmontierbare Leistungsbauteile verwendet, die mit ihrer rückseitigen Anschlußfläche auf einer Leiterplatte als Trägerkörper aufliegen. Um eine ausreichende Wärmeabfuhr der Verlustleistung der Bauteile zu gewährleisten (insbesondere der Verlustleistung der Leistungsbauteile) können einerseits zur Unterstützung des vertikalen Wärmetransports in den Trägerkörper thermische Durchkontaktierungen (sog. thermische vias) eingebracht werden, d.h. Durchkontaktierungen von der Oberseite zur Unterseite des Trägerkörpers; hierzu werden in der Regel direkt unter der rückseitigen Anschlußfläche (der Auflagefläche) der Bauteile (insbesondere der Leistungsbauteile) Durchführungen in den Trägerkörper eingebracht, die ganzflächig und durchgängig metallisiert werden (bsp. mittels einer Kupferbeschichtung) siehe z.B. EP-A-0055578. Andererseits kann zur externen Wärmeabfuhr der Trägerkörper auf einen metallischen Kühlkörper (bsp. eine Kupferplatte) aufgebracht werden, der die Verlustleistung an ein Kühlsystem weitergeben kann und der mittels einer elektrischen Isolationsschicht (bsp. mittels einer Isolationsfolie) vom Trägerkörper separiert ist.

Nach dem Aufbringen der Bauteile auf die Oberseite der Trägerplatte (die Bestückungsseite) werden diese in einem Lötprozeß mit Anschlußflächen (Pads) und/oder Leitbahnen einer metallischen Leitbahnstruktur kontaktiert, wobei Lotpaste auf die Anschlußflächen und die Oberfläche der thermischen vias gedruckt und in einem Reflow-Lötprozeß aufgeschmolzen wird. Hierbei können Lot oder Lotspritzer oder ebenfalls aufgeschmolzene Teile der metallischen Leitbahnstruktur aufgrund von Kapillareffekten durch die thermischen vias hindurch auf die Unterseite des Trägerkörpers gezogen werden und dort die elektrische Isolationsschicht beschädigen (bsp. kann eine auf der Unterseite des Trägerkörpers aufgebrachte Isolationsfolie durchstoßen werden) sowie elektrische Kurzschlüsse zum metallischen Kühlkörper hin oder zu einem den Trägerkörper und die Schaltungsanordnung umschließenden Gehäuse hin verursachen.

Der Erfindung liegt die Aufgabe zugrunde, ein Verfahren zur Herstellung von Schaltungsanordnungen mit vorteilhaften Eigenschaften bezüglich der Wärmeabfuhr, der Zuverlässigkeit, der Kosten und des Herstellungsprozesses anzugeben.
Diese Aufgabe wird gemäß der Erfindung durch die Merkmale im Kennzeichen des Patentanspruchs 1 gelöst.
Vorteilhafte Ausgestaltungen der Erfindung sind Bestandteil der weiteren Patentansprüche.

Erfindungsgemäß ist vorgesehen, daß vor dem Lötprozeß alle in den Trägerkörper eingebrachten thermischen Durchkontaktierungen (thermischen vias) von der der Oberseite (Bestückungsseite) des Trägerkörpers gegenüberliegenden Unterseite (Rückseite) des Trägerkörpers her mittels Siebdruck verschlossen werden. Hierzu wird um die thermischen vias herum ein Siebdruckfilm angeordnet und das Siebdruckmaterial in einem mindestens zweistufigen Druckvorgang von der Unterseite des Trägerkörpers her in die Öffnungen der thermischen vias eingedruckt. Für den Siebdruck werden hochviskose, thixotrope (pastöse) vorzugsweise lösungsmittelfreie Materialien verwendet, wobei das Siebdruckmaterial entsprechend dem Material des Trägerkörpers gewählt werden kann. Nach einer geeigneten Prüfung der verschlossenen Öffnungen (bsp. mittels optischer Kontrolle im Gegenlicht oder eines automatisierten Vakuumtests) wird der Trägerkörper getrocknet und das Siebdruckmaterial ausgehärtet. Beim anschließenden Lötprozeß der Bauteile der Schaltungsanordnung auf der Oberseite des Trägerkörpers (bsp. mittels eines Reflow-Lötprozesses) können somit Verunreinigungen der Unterseite des Trägerkörpers (insbesondere bedingt durch einen Lotdurchfluß von der Oberseite zur Unterseite des Trägerkörpers durch die thermischen vias hindurch) verhindert werden. Der Wärmetransport von der Oberseite zur Unterseite des Trägerkörpers wird durch das die thermischen vias verschließende Siebdruckmaterial jedoch nicht beeinträchtigt.

Bei Verwendung eines lösungsmittelfreien Siebdruckmaterials kann eine Volumenreduzierung des Siebdruckmaterials bei der Aushärtung vermieden werden, so daß keine Blasen oder Risse im Siebdruckmaterial entstehen können, die die Zuverläsigkeit des Verschlusses der thermischen vias beeeinträchtigen würden. Der Durchmesser der thermischen vias wird an die jeweils angewandte Siebdrucktechnik angepaßt und so vorgegeben, daß eine ausreichende Bedeckung der thermischen vias innerhalb des Öffnungsvolumens stattfindet (bsp. kann eine bestimmte minimale Befüllung innerhalb der thermischen vias gefordert werden) und daß keine oder nur eine geringe Bedeckung der an die thermischen vias angrenzenden Randbereiche auf der Unterseite des Trägerkörpers stattfindet (eine Bedeckung der auf der Unterseite des Trägerkörpers vorgesehenen Anschlußflächen mit Siebdruckmaterial würde den thermischen Übergang und damit das Abführen der Verlustwärme verschlechtern). Der Druckvorgang des Siebdruckmaterials in die thermischen vias wird so oft durchgeführt (mindestens jedoch zweimal hintereinander), bis die gewünschte Dicke des Siebdruckmaterials in den thermischen vias und eine vollständige flächenmäßige Bedeckung der sich auf der Unterseite des Trägerkörpers befindlichen Öffnungen der thermischen vias mit dem Siebdruckmaterial erfolgt ist.

Beim vorgestellten sicheren und einfachen Verfahren zur Herstellung von Schaltungsanordnungen kann vorteilhafterweise bei allen in den Trägerkörper eingebrachten thermischen vias ein Lotdurchfluß durch die thermischen vias hindurch mit geringen Kosten unabhängig von der Ausgestaltung der thermischen vias (unabhängig von der Art der Durchkontaktierung) auch bei größeren Durchmessern der thermischen vias (bsp. bei einem Durchmesser im Bereich von 0.4 mm bis 1 mm) ohne Beeinträchtigung des thermischen Übergangs vollständig verhindert werden.

Das Verfahren soll im folgenden anhand eines Ausführungsbeispiels im Zusammenhang mit der Zeichnung beschrieben werden.

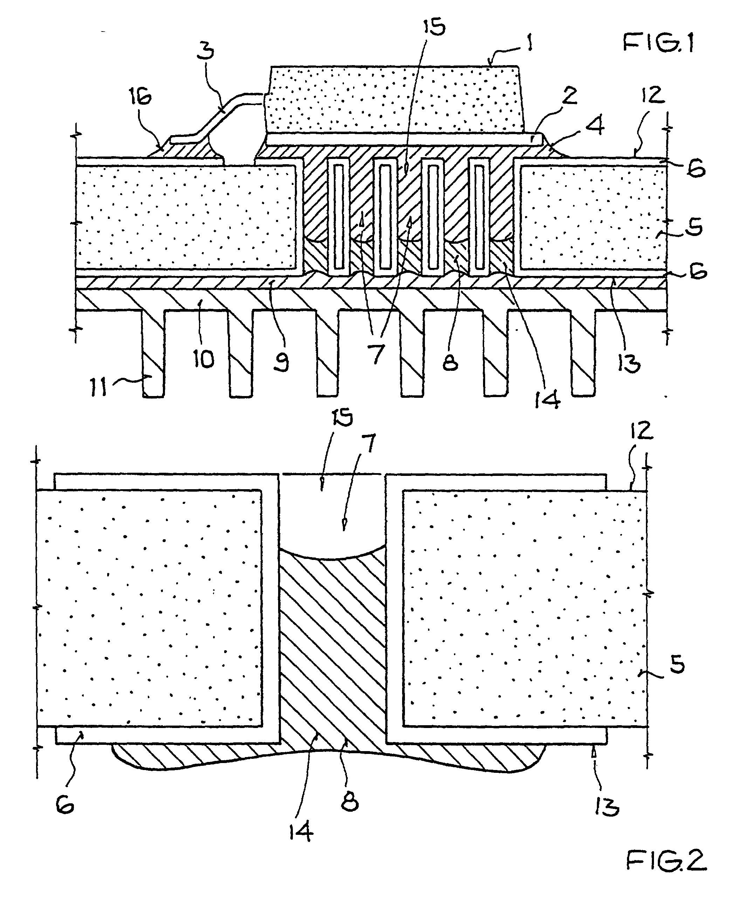

Hierzu ist in der Figur 1 in einer Schnittdarstellung ein Ausschnitt einer auf einem Trägerkörper aufgebrachten Schaltungsanordnung mit einem Leistungsbauteil dargestellt und in der Figur 2 die vergrößerte Darstellung einer thermischen Durchkontaktierung von der Oberseite zur Unterseite des Trägerkörpers.

Die auf der Oberseite 12 eines bsp. als Leiterplatte ausgebildeten Trägerkörpers 5 angeordnete Schaltungsanordnung weist neben weiteren aktiven und passiven Bauteilen auch mindestens ein Leistungsbauteil 1 auf, dessen Anschlußkontakte 3 mit der auf dem 5 Trägerkörper aufgebrachten, bsp. aus mit Nickel-Gold (AuNi) beschichtetem Kupfer bestehenden Leitbahnstruktur über die Anschlußfläche 16 kontaktiert werden sollen. Zum vertikalen Abführen der im Betrieb der Schaltungsanordnung - insbesondere durch die Leistungsbauteile 1 der Schaltungsanordnung - entstehenden Verlustleistung sind im Bereich aller Leistungsbauteile 1 der Schaltungsanordnung bsp. als Bohrungen ausgebildete Durchführungen in die Leiterplatte 5 eingebracht, deren Bewandungen zur Ausbildung thermischer Durchkontaktierungen 7 (thermischer vias) mittels einer Metallisierungsschicht 6 vollständig und ganzflächig belegt werden und deren Öffnungen 14, 15 nach der Metallisierung einen Durchmesser von bsp. 0,5 mm aufweisen. Die Leistungsbauteile 1 liegen mit ihrer Kühlfahne 2 auf den auf der Oberseite der Leiterplatte 5 befindlichen Öffnungen 15 der thermischen vias 7 auf, so daß ein effizienter Wärmeübergang von der Oberseite 12 der Leiterplatte 5 zur Unterseite 13 der Leiterplatte 5 ermöglicht wird. Von der Unterseite 13 der Leiterplatte 5 wird die Verlustwärme mittels des mit Kühlrippen 11 versehenen, als Kühlblech ausgebildeten metallischen Kühlkörpers 10 an ein Kühlsystem abgeführt. Zwischen der Unterseite 13 der Leiterplatte 5 und dem Kühlblech 10 ist zur elektrischen Isolation eine thermisch leitfähige, elektrisch isolierende Folie 9 angeordnet.
Bsp. sollen die Bauteile der Schaltungsanordnung auf die Oberseite 12 der Leiterplatte 5 mittels eines Reflow-Lötprozesses aufgelötet werden. Um einen Durchfluß des Lots 4 von der Oberseite 12 der Leiterplatte 5 zur Unterseite 13 der Leiterplatte 5 beim Löten der Bauteile auf der Oberseite 12 (Reflowseite oder Bestückungsseite) der Leiterplatte 5 zu verhindern, werden die thermischen vias 7 von der Unterseite 13 der Leiterplatte 5 her vor dem Lötprozeß mittels eines Siebdruckprozesses verschlossen.
Zum Verschließen der thermischen vias 7 wird auf der Unterseite 13 der Leiterplatte 5 um die bsp. einen Durchmesser von 0.5 mm aufweisenden Öffnungen 14 der thermischen vias 7 herum ein Siebdruckfilm mit einem Durchmesser von bsp. 0.7 mm aufgebracht. Das Siebdruckmaterial 8, bsp. ein Feststoff-Epoxymaterial, wird durch einen zweistufigen Druckvorgang (Doppeldruck, zweimaliger naß-in-naß-Druck) derart in die auf der Unterseite 13 der Leiterplatte 5 befindlichen Öffnungen 14 der thermischen vias 7 gedruckt, daß der Schichtauftrag des Siebdruckmaterials 8 auf der Oberfläche der Unterseite 13 der Leiterplatte 5 (d.h. die Dicke des im Bereich der Öffnungen 14 über die Unterseite 13 der Leiterplatte 5 überstehenden Siebdruckmaterials 8 und inbesondere die Dicke des sich im Bereich um die Öffnungen 14 herum auf der Leiterplatte 5 befindlichen Siebdruckmaterials 8) so gering wie möglich gehalten wird (bsp. Schichthöhe < 60 µm), daß eine bestimmte minimale Füllhöhe des Siebdruckmaterials 8 in den thermischen vias 7 an der engsten Stelle der thermischen vias 7 erreicht wird (bsp. soll die Füllhöhe mindestens 15 % der Dicke der Leiterplatte 5 betragen) und daß das ausgehärtete Siebdruckmaterial 8 keine Defekte (bsp. Einschlüsse, Luftblasen, Poren etc.) aufweist.

## Patentansprüche

1. Verfahren zur Herstellung von Schaltungsanordnungen, deren Bauteile mittels eines Lötprozesses auf die Oberseite (12) eines thermische Durchkontaktierungen (7) aufweisenden Trägerkörpers (5) aufgebracht werden,
**dadurch gekennzeichnet,**
**daß** die thermischen Durchkontaktierungen (7) vor dem Lötprozeß von der zur die Bauteile aufnehmenden Oberseite (12) gegenüberliegenden Unterseite (13) des Trägerkörpers (5) her mittels eines mindestens zwei Druckvorgänge beinhaltenden Siebdruckprozesses mit einem hochviskosen, lösungsmittelfreien Siebdruckmaterial verschlossen werden.

2. Verfahren nach Anspruch 1, **dadurch gekennzeichnet, daß** die thermischen Durchkontaktierungen (7) mittels eines Siebdruckfilms abgedeckt werden, daß in die sich auf der Unterseite (13) des Trägerkörpers (5) befindlichen Öffnungen (14) der thermischen Durchkontaktierungen (7) Siebdruckmaterial (8) eingebracht wird, daß das Siebdruckmaterial (8) getrocknet und ausgehärtet wird, und daß nach dem Aushärten des Siebdruckmaterials (8) die Bauteile der Schaltungsanordnung mittels eines Reflow-Lötprozesses auf die Oberseite (12) des Trägerkörpers (5) aufgebracht werden.

3. Verfahren nach Anspruch 1 oder 2, **dadurch gekennzeichnet, daß** nach dem Aushärten des Siebdruckmaterials (8) der Verschluß der auf der Unterseite (13) des Trägerkörpers (5) befindlichen Öffnungen (14) der thermischen Durchkontaktierungen (7) kontrolliert wird.

4. Verfahren nach einem der Ansprüche 1 bis 3, **dadurch gekennzeichnet, daß** die Leistungsbauteile (1) der Schaltungsanordnung mit einer Kühlfahne (2) auf den auf der Oberseite (12) des Trägerkörpers (5) befindlichen Öffnungen (15) der thermischen Durchkontaktierungen (7) angeordnet werden.

## Claims

1. Method for making circuit assemblies, the components of which are applied by means of a soldering process to the top side (12) of a substrate (5) comprising thermal feed-throughs (7),
**characterised in**
**that** the thermal feed-throughs (7) are sealed before the soldering process from the underside (13), which lies opposite the top side (12) accommodating the components, of the substrate (5) by means of a screen printing process, which includes at least two printing operations, with a highly viscous, solvent-free screen printing material.

2. Method according to Claim 1, **characterised in that** the thermal feed-throughs (7) are covered by means of a screen printing film, that screen printing material (8) is introduced into the openings (14), which are located at the underside (13) of the substrate (5), of the thermal feed-throughs (7), that the screen printing material (8) is dried and hardened, and that the components of the circuit assembly are applied to the top side (12) of the substrate (5) by means of a reflow soldering process after the screen printing material (8) has hardened.

3. Method according to Claim 1 or 2, **characterised in that** the seal of the openings (14), located at the underside (13) of the substrate (5), of the thermal feed-throughs (7) is checked after the screen printing material (8) has hardened.

4. Method according to any one of Claims 1 to 3,
**characterised in that** the power components (1) of the circuit assembly are disposed with a cooling vane (2) on the openings (15), located at the top side (12) of the substrate (5), of the thermal feed-throughs (7).

## Revendications

1. Procédé pour fabriquer des montages, dont les composants apposés au moyen d'un processus de brasage sur la face supérieure (12) d'un support (5) qui possède des contacts thermiques traversants (7), **caractérisé en ce qu'**avant l'opération de brasage les contacts thermiques traversants (7) sont fermés à partir de la face inférieure (13) du corps de support (5) située à l'opposé de la face supérieure (12) recevant les composants, à l'aide d'un processus de sérigraphie comprenant au moins deux processus d'impression, à l'aide d'un matériau de sérigraphie très visqueux, ne comportant aucun solvant.

2. Procédé selon la revendication 1, **caractérisé en ce qu'**on recouvre les contacts thermiques traversants (7) avec un film de sérigraphie, qu'on introduit un matériau de sérigraphie (8) dans les ouvertures (14), situées dans la face inférieure (13) du corps de support (5), des contacts thermiques traversants (7), qu'on fait sécher et durcir le matériau de sérigraphie (8) et qu'après le durcissement du matériau de sérigraphie (8), on installe les composants du montage à l'aide d'un processus de brasage à reflow sur la face supérieure (12) du corps de support (5).

3. Procédé selon la revendication 1 ou 2, **caractérisé en ce qu'**après le durcissement du matériau de sérigraphie (8), on contrôle la fermeture des ouvertures (14), qui sont situés dans la face supérieure (13) du corps de support (5), des contacts thermiques traversants (7).

4. Procédé selon l'une des revendications 1 à 3, **caractérisé en ce que** les composants de puissance (1) du montage sont disposés avec une languette de refroidissement (2) sur les ouvertures (15), qui sont situés dans la face supérieure (12) du corps de support (5), des contacts thermiques traversants (7).
